(19) Europäisches Patentamt
European Patent Office
Office européen des brevets

(11) **EP 3 038 165 A1**

(12) **DEMANDE DE BREVET EUROPEEN**

(43) Date de publication:
**29.06.2016 Bulletin 2016/26**

(21) Numéro de dépôt: **15201368.6**

(22) Date de dépôt: **18.12.2015**

(51) Int Cl.:
*H01L 31/0352* (2006.01)   *H01L 31/068* (2012.01)
*H01L 31/18* (2006.01)   *H01L 21/761* (2006.01)
*H01L 21/04* (2006.01)   *H01L 31/047* (2014.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(30) Priorité: **22.12.2014 FR 1463124**

(71) Demandeur: **COMMISSARIAT A L'ENERGIE ATOMIQUE ET AUX ENERGIES ALTERNATIVES 75015 Paris (FR)**

(72) Inventeurs:
• **DUBOIS, Sébastien**
  **74950 SCIONZIER (FR)**
• **ENJALBERT, Nicolas**
  **81100 BURLATS (FR)**
• **GARANDET, Jean-Paul**
  **92210 SAINT CLOUD (FR)**
• **MARTEL, Benoît**
  **73200 GILLY SUR ISERE (FR)**
• **VEIRMAN, Jordi**
  **74330 POISY (FR)**

(74) Mandataire: **Nony**
  **11 rue Saint-Georges**
  **75009 Paris (FR)**

(54) **PLAQUETTE DE SILICIUM MONOLITHIQUE TYPE P/TYPE N**

(57) La présente invention concerne un procédé de fabrication d'une plaquette (10) d'épaisseur (e), comprenant au moins les étapes consistant en (i) disposer d'un substrat monolithique en silicium dopé p ; (ii) former des défauts cristallographiques sur des parties prédéfinies d'au moins l'une des faces du substrat ; (iii) soumettre le substrat à un recuit thermique ; (iv) mettre en contact tout ou partie de l'une des faces du substrat avec de l'hydrogène ; (v) si nécessaire, favoriser la diffusion de l'hydrogène ; et (vi) soumettre le substrat à un traitement thermique.

**FIGURE 1**

EP 3 038 165 A1

## Description

La présente invention se rapporte à une nouvelle plaquette de silicium monolithique type p/type n, et à un procédé pour sa préparation. Une telle plaquette est particulièrement avantageuse dans le cadre de l'élaboration de cellules et modules photovoltaïques, en particulier à « haute-tension ».

Actuellement, les modules photovoltaïques (PV) sont majoritairement fabriqués à partir de l'assemblage de cellules en silicium mono- ou multi-cristallin, ces cellules étant généralement réalisées à partir de plaquettes, également appelées « wafers », de conductivité électrique p.

Dans des modules PV de taille raisonnable, de l'ordre du $m^2$, le standard de taille pour les plaquettes (156 x 156 $mm^2$) fait que les tensions de circuit ouvert ($V_{oc}$ en terminologie anglo-saxonne) des modules PV sont limitées à quelques dizaines de Volts.

Différentes voies ont été explorées pour tenter d'augmenter la tension $V_{oc}$ des modules PV.

Par exemple, récemment, Pozner *et al.* [1] ont envisagé par modélisation la mise en série de cellules à plans de jonction p/n verticaux, à la différence de la configuration des wafers classiques où le plan de jonction est horizontal. L'intérêt de cette approche est de pouvoir envisager un traitement de type collectif, sur substrat monolithique, pour la réalisation des cellules. Toutefois, de nombreuses questions techniques restent ouvertes quant à la réalisation en pratique d'une telle structure, dont le coût risque, par ailleurs, d'être très élevé.

Gatos *et al.* [2] proposent de tirer parti de l'incorporation hétérogène d'oxygène au cours de la croissance d'un cristal de silicium par solidification dirigée selon le procédé Czochralski. L'origine de ces fluctuations de concentration d'oxygène est mal connue, mais ce principe est utilisé par Gatos *et al.* pour obtenir des structures de conductivité alternée n/p par recuit thermique.

Il est en effet connu de l'état de l'art [3] que, dans des plaquettes de silicium contenant de l'oxygène, des recuits thermiques à des températures de 400-500 °C permettent la formation de donneurs thermiques (DT), petits agglomérats d'oxygène (typiquement formés de l'association de 3 à 20 atomes d'oxygène) qui se comportent en donneurs d'électrons dans le silicium. Ainsi, lorsque ces donneurs thermiques sont générés dans le silicium de type p, ils peuvent entraîner une compensation du matériau et son changement de conductivité. La libération d'électrons étant fonction de la concentration locale en oxygène, un recuit, par exemple à une température de 450 °C pendant 50 heures d'une plaquette découpée dans un lingot Czochralski parallèlement à la direction de solidification, permet ainsi d'obtenir des structures p/n.

Malheureusement, les fluctuations de concentration n'étant pas maitrisées, la taille des zones n et p, typiquement de l'ordre de la centaine de microns [2], ne peut être contrôlée. Il n'est donc pas possible de contrôler la tension de sortie d'une telle structure, ce qui représente un obstacle majeur pour l'intégration de ces structures dans un système solaire complet.

En outre, la variation de taille entre les différentes sous-cellules sur la surface d'une plaquette induit une complexité, d'un point de vue technologique, qui représente un inconvénient majeur pour la réalisation des cellules photovoltaïques.

Une autre option pour accéder à ce type de plaquettes repose sur une hydrogénation locale du matériau formant la plaquette, suivie d'un recuit d'activation (typiquement effectué à 450 °C) des donneurs thermiques (agglomérats d'atomes d'oxygène ayant un comportement donneur d'électron). En effet, l'hydrogène accélère la formation des donneurs thermiques. Ainsi, en partant d'une plaquette initialement de type p, à l'issue du recuit, les zones hydrogénées seront de type n, et les zones non-hydrogénées resteront de type p.

Cependant, l'introduction d'hydrogène sur toute l'épaisseur d'une plaquette de silicium (typiquement voisine de 200 $\mu$m pour les plaquettes utilisées par l'industrie PV) est en pratique difficile à effectuer, en particulier lorsque les substrats sont monocristallins (absence de joints de grains, densités de dislocations inférieures à $10^2$ $cm^{-2}$).

De tels substrats peuvent être obtenus par tirage Czochralski (Cz), par la technique dite de la Fusion de Zone (FZ), par croissance par épitaxie ou encore par solidification dirigée assistée par un germe.

En effet, Dubois *et al.* [4] ont montré que lors de la fabrication des cellules solaires photovoltaïques, l'hydrogène, issu initialement de la couche anti-reflet de la cellule qui est un nitrure de silicium hydrogéné (SiNx:H), ne migrait que sur une distance limitée, voisine de quelques dizaines de micromètres et donc bien inférieure à l'épaisseur de la cellule.

Il est donc nécessaire de développer des procédés permettant de pallier les insuffisances détaillées ci-dessus des procédés déjà existants.

La présente invention vise précisément à proposer une nouvelle plaquette de silicium monolithique type p / type n permettant de pallier les inconvénients précités, ainsi que des procédés pour accéder à une telle plaquette.

Plus précisément, la présente invention concerne, selon un premier de ses aspects, des procédés permettant d'accéder, de manière aisée, à une plaquette type p / type n, à partir d'une plaquette en silicium dopé p.

La présente invention concerne en particulier un procédé pour fabriquer des plaquettes telles que définies ci-après, procédé plus particulièrement intéressant pour son aptitude à permettre une génération volontaire et contrôlée de dislocations dans le volume d'une plaquette en silicium monocristallin dans le but d'améliorer les effets d'hydrogénation du volume.

Ainsi, la présente invention concerne un procédé de fabrication d'une plaquette (10) d'épaisseur (e), notamment de silicium monolithique type p / type n, de préférence telle que définie ci-après, comprenant au moins les étapes consistant en :

(i) disposer d'un substrat monolithique en silicium dopé p comprenant une concentration en porteurs de charge de type trous $p_0$ comprise entre $10^{14}$ et $4x10^{16}$ cm$^{-3}$ et une concentration en oxygène interstitiel $[O_i]$ comprise entre $4x10^{17}$ et $2x10^{18}$ cm$^{-3}$ ;

(ii) former des défauts cristallographiques sur des parties prédéfinies d'au moins l'une des faces du substrat, lesdites parties, dites régions riches en déformation, étant espacées les unes des autres d'une distance d comprise entre 5 $\mu$m et e/2, la distance d étant mesurée selon une section transversale verticale ;

(iii) soumettre le substrat à un recuit thermique dans des conditions propices à la propagation de dislocations depuis lesdites régions riches en déformation sur toute l'épaisseur du substrat ;

(iv) mettre en contact tout ou partie de l'une des faces du substrat avec de l'hydrogène dans des conditions adaptées à la diffusion de l'hydrogène le long des dislocations propagées à l'étape (iii) ;

(v) si nécessaire, favoriser la diffusion de l'hydrogène ; et

(vi) soumettre le substrat à un traitement thermique dans des conditions propices à l'activation des donneurs thermiques à base d'oxygène dans les zones riches en dislocations pour les convertir en zones n, et obtenir la plaquette attendue.

Dans la suite du texte, et sauf indication contraire, la plaquette est caractérisée lorsqu'elle est observée dans sa position horizontale.

On parlera indifféremment dans la suite du texte de « plaquette » ou de « wafer ».

On désignera par la suite par « donneurs thermiques », ou plus simplement sous l'abréviation « DT », les donneurs thermiques à base d'oxygène.

L'étape (iv) peut être réalisée entre les étapes (iii) et (vi), mais également préalablement à l'étape (ii) ou préalablement à l'étape (iii).

L'étape (v) peut être réalisée entre les étapes (iii) et (vi). En alternative, elle peut être réalisée simultanément à l'étape (iii). Bien entendu, l'étape (iv) est alors réalisée préalablement à l'étape (ii) ou préalablement à l'étape (iii).

L'étape (v) peut encore être réalisée simultanément à l'étape (vi).

Comme il ressort de ce qui suit, le procédé selon l'invention permet d'hydrogéner efficacement, et de manière contrôlée en terme de localisation, des zones prédéfinies du substrat.

Ce résultat repose en particulier sur la formation locale en surface du substrat de défauts cristallographiques, qui permettent de maîtriser, avec précision, la taille des zones n et p formées dans la plaquette finale.

Egalement, il est possible selon l'invention, comme développé dans la suite du texte, de réaliser des structures bidimensionnelles, par exemple avec une disposition des zones n et p alternées en quadrillage, ce qui permet avantageusement d'accroître encore le nombre de sous-cellules en série formées sur la plaquette.

En particulier, la plaquette (10) de silicium monolithique type p / type n, présente, dans un plan vertical de coupe, une alternance de zones dopées n et de zones dopées p, caractérisée en ce que :

- chacune des zones dopées n et dopées p s'étend sur toute l'épaisseur e de la plaquette,
- deux zones dopées n sont séparées l'une de l'autre dans un plan vertical de coupe par une zone dopée p, et
- les zones dopées n présentent une concentration en donneurs thermiques à base d'oxygène et une densité de dislocations moyenne supérieures à celles des zones dopées p.

Selon encore un autre de ses aspects, la présente invention concerne un dispositif photovoltaïque, en particulier une cellule photovoltaïque, comportant une plaquette de silicium telle que définie précédemment.

Les plaquettes de silicium selon l'invention, divisées en une pluralité de sous-cellules de tailles contrôlées, permettent avantageusement de produire des modules PV présentant une tension de circuit ouvert accrue, tout en conservant une taille raisonnable standard de l'ordre du m$^2$.

L'expression « défauts cristallographiques » se réfère aux défauts classiquement connus des matériaux monocristallins, à savoir aux dislocations, vides, macles, lacunes et auto-interstitiels.

D'autres caractéristiques, avantages et modes d'application des plaquettes selon l'invention et du procédé pour sa préparation, ressortiront mieux à la lecture de la description détaillée qui va suivre, des exemples de réalisation de l'invention et à l'examen des dessins annexés, sur lesquels :

- la figure 1 représente, de manière schématique, dans un plan vertical de coupe, la structure d'une plaquette de silicium obtenue selon l'invention ; et

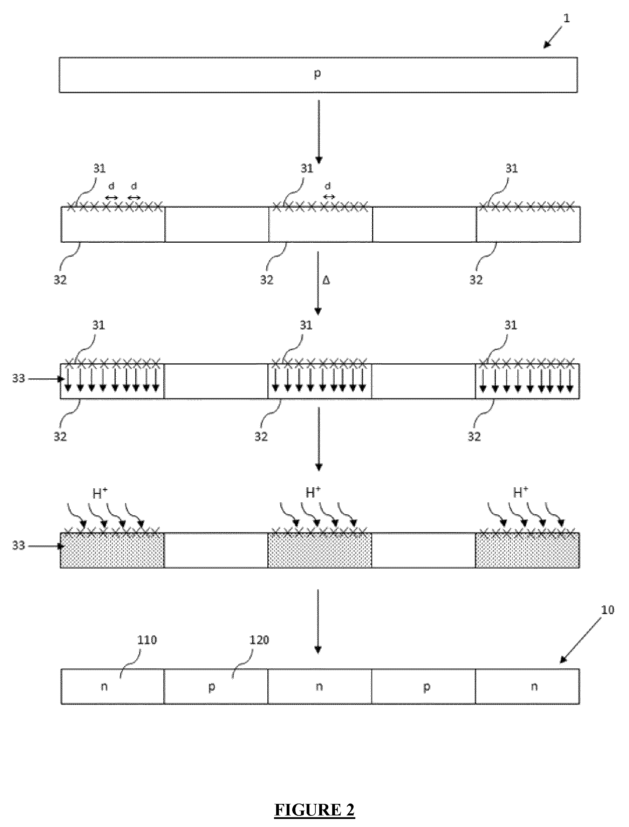

- la figure 2 représente, de manière schématique, les différentes étapes du procédé de fabrication d'une plaquette selon l'invention, selon un premier mode de réalisation.

Il convient de noter que, pour des raisons de clarté, les différents éléments sur les figures sont représentés en échelle libre, les dimensions réelles des différentes parties n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

## FABRICATION D'UNE PLAQUETTE DE SILICIUM MONOLITHIQUE TYPE P / TYPE N

Comme évoquée précédemment, la présente invention concerne un procédé de fabrication d'une plaquette 10 d'épaisseur (e), notamment de silicium monolithique type p / type n, et présentant, dans un plan vertical de coupe, une alternance de zones dopées n et de zones dopées p, et en particulier telle que définie ci-après, comprenant au moins les étapes consistant en :

(i) disposer d'un substrat monolithique en silicium dopé p comprenant une concentration en porteurs de charge de type trous $p_0$ comprise entre $10^{14}$ et $4 \times 10^{16}$ cm$^{-3}$ et une concentration en oxygène interstitiel $[O_i]$ comprise entre $4 \times 10^{17}$ et $2 \times 10^{18}$ cm$^{-3}$ ;
(ii) former des défauts cristallographiques sur des parties prédéfinies d'au moins l'une des faces du substrat, lesdites parties, dites régions riches en déformation, étant espacées les unes des autres d'une distance d comprise entre 5 $\mu$m et e/2, la distance d étant mesurée selon une section transversale verticale ;
(iii) soumettre le substrat, à un recuit thermique dans des conditions propices à la propagation de dislocations depuis lesdites régions riches en déformation sur toute l'épaisseur du substrat;
(iv) mettre en contact tout ou partie de l'une des faces du substrat avec de l'hydrogène dans des conditions adaptées à la diffusion de l'hydrogène le long des dislocations propagées en étape (iii) ;
(v) si nécessaire, favoriser la diffusion de l'hydrogène ; et
(vi) soumettre le substrat à un traitement thermique dans des conditions propices à l'activation des donneurs thermiques à base d'oxygène dans les zones riches en dislocations pour les convertir en zones n, et obtenir la plaquette attendue.

Avantageusement, le substrat 1 présente des plans cristallographiques (111) perpendiculaires à la surface exposée.
De tels plans cristallographiques (111) sont avantageux dans le cadre de la présente invention, ils constituent les plans préférentiels de propagation des dislocations dans les semi-conducteurs tels que le silicium.

### Etape (i) : Substrat monolithique en silicium dopé p

D'une manière générale, le substrat 1 en silicium dopé p, à traiter selon l'invention, comprend une concentration en porteurs de charge de type trous $p_0$ comprise entre $10^{14}$ et $4 \times 10^{16}$ cm$^{-3}$ et une concentration en oxygène interstitiel $[O_i]$ comprise entre $4 \times 10^{17}$ et $2 \times 10^{18}$ cm$^{-3}$.

Selon un mode de réalisation particulier, le substrat en silicium dopé p présente une concentration en oxygène interstitiel $[O_i]$ allant de $4 \times 10^{17}$ à $1,5 \times 10^{18}$ cm$^{-3}$.
De manière avantageuse, la variation relative de la concentration en oxygène interstitiel dans le substrat en silicium 1 est inférieure à 40 %, en particulier inférieure à 20 % et de préférence inférieure à 10 %.
Selon un mode de réalisation particulier, le substrat en silicium dopé p présente une concentration en porteurs de charge de type trous $(p_0)$ allant de $10^{15}$ cm$^{-3}$ à $2 \times 10^{16}$ cm$^{-3}$.
La concentration en porteurs de charge de type trous peut être par exemple déduite d'une mesure d'effet Hall.
De préférence, le substrat est monocristallin. Un tel substrat en silicium dopé p peut être par exemple obtenu par découpe d'un lingot de silicium formé, selon des techniques connues de l'homme du métier, par solidification dirigée d'un bain fondu, en particulier par la technique de refroidissement sous gradient (encore connue sous l'appellation « gradient freeze » en langue anglaise) ou par épitaxie en voie liquide ou gazeuse.
Le substrat peut présenter les dimensions indiquées précédemment pour la plaquette.

### Etape (ii) : Formation des défauts cristallographiques

Le procédé selon l'invention requiert la création de défauts cristallographiques sur la surface d'au moins une des faces du substrat.
Les parties « prédéfinies » sont dédiées à former dans l'épaisseur du substrat, à l'issue du procédé de l'invention, les zones dopées n de la plaquette finale.
Sur chacune des parties prédéfinies 31,32, des défauts cristallographiques peuvent être créés en déformant plastiquement une région du substrat située sous chacune des parties prédéfinies. Une telle déformation plastique peut être obtenue par application d'une force sur les parties prédéfinies.
Les parties prédéfinies, intégrant des défauts cristallographiques, sont également dites « régions riches en déformation ».
Une région riche en déformation peut être définie en comparaison d'une région pauvre en déformation par une valeur de déformation $\Delta L/L$ au moins supérieure ou égale à 2 fois et de préférence au moins supérieure ou égale à 3 fois la déformation d'une région pauvre en déformation. L est la longueur initiale d'un matériau, $\Delta L$ correspond à la variation de cette longueur lorsqu'une déformation est appliquée au matériau. La valeur de cette déformation (aussi appelée « strain value » en anglais) peut être déterminée par n-XRD (nano X-ray diffraction).
Les parties prédéfinies sont encore qualifiées de parties endommagées. Les dislocations seront ultérieurement générées à partir de ces zones riches en déformation pour se propager sur toute l'épaisseur du substrat.

Selon un mode de réalisation particulier, les régions riches en déformation sont espacées les unes des autres d'une distance d comprise entre 5 $\mu$m et e/2, en particulier entre 5 $\mu$m et 100 $\mu$m, de préférence entre 10 $\mu$m et 50 $\mu$m.

Il est entendu que ces régions riches en déformations sont présentes sur les parties dédiées à former les futures zones dopées n (110) de la plaquette obtenue selon le procédé selon l'invention.

Ainsi, une future zone dopée n (110) d'une plaquette formée selon le procédé de l'invention comprend plusieurs régions riches en déformations, et en particulier est constituée de zones surfaciques riches en déformations espacées par des zones pauvres en déformation.

Selon une première variante de réalisation, en étape (ii), des défauts cristallographiques sont formés sur une seule face du substrat.

Selon une seconde variante de réalisation, les défauts cristallographiques sont formés sur les deux faces opposées du substrat. Les parties prédéfinies 31,32 sont de préférence disposées symétriquement par rapport au plan longitudinal médian du substrat, de sorte à ce que les zones dopées n de la plaquette formée à l'issue de l'étape (vi) soient substantiellement verticales et parallèles à l'épaisseur du substrat.

De préférence, les parties prédéfinies 31,32 forment un réseau de bandes parallèles ou un quadrillage en surface du substrat.

Les défauts cristallographiques peuvent être formés en rayant la surface desdites parties prédéfinies 31,32 à l'aide d'une pointe, en particulier une micro-pointe, de préférence en diamant ou métallique.

Selon une autre variante de réalisation, les défauts cristallographiques peuvent être formés par exposition de la surface desdites parties prédéfinies à un rayonnement laser.

Une telle déformation par rayonnement laser est habituellement dénommée « shot peening » en anglais et est bien connue de l'homme du métier.

De préférence, le rayonnement laser est réalisé avec un faisceau laser dont la taille de faisceau est comprise entre 1 $\mu$m et 20 $\mu$m, de préférence entre 2 $\mu$m et 5 $\mu$m. Le faisceau laser présente de préférence une ou plusieurs longueurs d'onde supérieure(s) ou égale(s) à 100 nm, notamment comprise(s) entre 400 et 5 000 nm.

Plusieurs sources de rayonnement laser peuvent être utilisées, de façon à former un peigne de faisceaux qui sont régulièrement espacés, afin d'exposer simultanément les parties prédéfinies.

Alternativement, il est possible d'exposer successivement plusieurs parties prédéfinies.

*Etape (iii) : Recuit thermique*

L'étape (iii) a pour objectif de permettre la propagation, depuis les régions riches en déformation, de dislocations sur toute l'épaisseur du substrat.

On parlera dans la suite du texte de « zones riches en dislocations » pour désigner les zones sous-jacentes aux régions riches en déformation formées en étape (ii) dans lesquelles sont propagées les dislocations. Ces zones riches en dislocations sont plus particulièrement les zones dédiées à former les zones dopées n à l'issue de l'étape (vi) du procédé de l'invention.

Comme mentionné précédemment, le recuit thermique peut être réalisé ou non conjointement à la diffusion de l'hydrogène le long des dislocations ainsi générées et au sein du substrat.

Le recuit thermique peut être réalisé dans un four.

Le recuit en étape (iii) peut être par exemple opéré à une température supérieure ou égale à 450 °C et inférieure ou égale à 1 100 °C, en particulier allant de 500 à 900°C.

La durée du recuit thermique peut être inférieure ou égale à 3 heures, en particulier être comprise entre 5 minutes et 2 heures, notamment être comprise entre 10 minutes et 1 heure.

Un tel recuit peut permettre d'amorcer la dissolution (encore appelée « annihilation ») de l'ensemble des DT.

En particulier, le recuit thermique de l'étape (iii) peut être réalisé sous contraintes mécaniques.

De telles contraintes mécaniques permettent d'accélérer l'effet de propagation des dislocations depuis les régions riches en déformation situées à la surface du substrat, selon toute son épaisseur.

Les contraintes mécaniques en étape (iii) peuvent être générées en imposant sur la longueur du substrat une variation non linéaire de la température.

En particulier, dans le cas où le substrat présente la forme d'un bloc ou d'une plaque, le profil non linéaire de température peut consister en une variation de type parabolique de la température entre le centre et les bords opposés du substrat.

De cette manière, des contraintes uniformes sont introduites le long du substrat. En effet, la contrainte $\sigma$ associée à une variation de température au sein du substrat le long d'une direction x s'exprime selon la relation suivante :

$$\sigma = \alpha\, E\, W^2 \frac{\partial^2 T}{\partial x^2}$$

dans laquelle :

- $\alpha$ est le coefficient de dilatation thermique du silicium (environ 3x10$^{-6}$ K$^{-1}$),
- E est le module de Young du silicium (1.65x10$^{11}$ Pa),
- W est un coefficient relié à la dimension du substrat que l'homme du métier sait déterminer à partir des dimensions du substrat (en mètres [m]).

Afin d'imposer une variation non-linéaire de la température entre le centre du substrat et les deux bords opposes, toute technique connue de l'homme du métier peut être mise en oeuvre. Par exemple, l'homme du métier sait mettre en oeuvre des sources de chaleur « froides » et « chaudes », appliquées respectivement au centre du substrat et sur les bords, de sorte à ce que la variation de température le long d'une direction perpendiculaire aux bords opposés et qui relie lesdits bords soit non-linéaire, de préférence de parabolique.

La variation de température entre les bords et le centre du substrat peut varier entre 0,1 °C et 100 °C, de préférence entre 2 °C et 10 °C. La contrainte résultant d'une variation de température peut varier entre 5 MPa et 2 000 MPa, de préférence entre 10 MPa et 300 MPa.

Les contraintes peuvent être également générées par mise en flexion du substrat. Ce mode de réalisation permet d'introduire directement des contraintes mécaniques dans le substrat.

Pour une mise en flexion de type 3 points, la contrainte maximale résultant de la mise en flexion d'un substrat sous forme d'une plaque dont le côté fléchi est de longueur L est reliée à la force F appliquée via la relation suivante :

$$\sigma_m = \frac{FLh}{8I}$$

avec

$$I = \frac{Lh^3}{12}$$

dans laquelle h est l'épaisseur du substrat.

De préférence, dans le substrat fléchi, la contrainte maximale induite par la mise en flexion est comprise entre 5 MPa et 2 000 MPa.

Par exemple, lors de l'étape de recuit, le substrat peut être mis en flexion en posant ses deux extrémités sur deux supports constitués de silicium et en appliquant un chargement mécanique au centre du substrat, par exemple sous la forme du poids d'un corps, par exemple en silicium.

Ce mode de réalisation permet d'entraîner la génération de contraintes mécaniques, qui permettent aux dislocations de se propager sur toute l'épaisseur du substrat.

Afin d'éviter tout risque de contamination, les supports maintenant le substrat en flexion et le corps dont le poids exerce une force au centre du substrat peuvent être silicium de haute pureté, et de préférence sous la forme de billes de silicium.

En particulier, la masse du corps peut être adaptée en fonction de la température de l'étape (iii) de recuit thermique. De préférence, la masse du corps est comprise entre 0,3 g et 30 g. L'homme du métier est à même d'adapter la masse du corps en fonction de la température et des dimensions du substrat.

Selon un mode de réalisation préféré, les contraintes mécaniques sont générées à la fois en imposant sur la longueur de la plaquette une variation non linéaire de la température et par mise en flexion de la plaquette.

Ainsi, les dislocations servent de « canaux » de diffusion pour l'hydrogène mis en contact avec le substrat selon l'étape (iv) décrite ci-après.

*Etape (iv) : Hydrogénation*

Cette étape requiert la mise en contact de l'hydrogène avec le substrat de sorte à ce que l'hydrogène puisse diffuser au moins dans les zones riches en dislocations formées à l'étape (iii).

Il appartient à l'homme du métier d'ajuster les taux de dopage en hydrogène des zones riches en dislocations du substrat pour obtenir la conversion souhaitée des zones en étape (vi), sans affecter les autres régions du substrat dédiées à former les zones p de la plaquette.

Généralement, le dopage est opéré de manière à permettre une distribution volumique uniforme de l'hydrogène dans les zones riches en dislocations et sur toute l'épaisseur du substrat.

L'introduction de l'hydrogène peut être effectuée par des techniques classiques, par exemple par traitement plasma, notamment par dépôt chimique en phase vapeur assisté par plasma (PECVD) ou par plasma d'hydrogène distant induit par micro-ondes (MIRHP).

De préférence, elle est opérée par une technique d'implantation ionique ou par dépôt d'une couche comportant de l'hydrogène (par exemple par PECVD), notamment de nitrure de silicium hydrogéné.

Il appartient à l'homme du métier d'ajuster les taux surfaciques d'hydrogène introduit, notamment au regard de l'épaisseur du substrat, de manière à obtenir les taux de dopage volumique souhaités, à l'issue de la diffusion de l'hydrogène sur toute l'épaisseur du substrat.

Par exemple, l'étape (iv) peut être menée de sorte que le taux de dopage volumique des zones riches en dislocations dédiées à former les zones dopées n soit compris entre $1 \times 10^{12}$ cm$^{-3}$ et $4 \times 10^{14}$ cm$^{-3}$.

Avantageusement, la diffusion de l'hydrogène, successive à sa mise en contact le substrat, peut être opérée par recuit thermique du substrat, notamment dans un four, en particulier à une température allant de 450 °C à 1 100 °C, et pendant une durée inférieure ou égale à 3 heures.

Ce traitement thermique peut être celui de l'étape (iii) dédiée à former les dislocations lorsque l'étape d'hydrogénation est réalisée antérieurement à l'étape (ii) ou à l'étape (iii).

Selon un mode de réalisation préféré, l'hydrogène est mis en contact avec une seule des faces du substrat, en particulier de la totalité de la surface de l'une des faces du substrat.

Selon un autre mode de réalisation, l'hydrogène est mis en contact avec les deux faces opposées du substrat, notamment après que celui-ci ait subi l'étape (iii).

L'hydrogène peut être mis au contact de toute la surface d'au moins l'une des faces du substrat. En variante, l'hydrogène peut être mis au contact seulement au niveau des parties prédéfinies de l'étape (ii).

Selon une variante de réalisation, l'hydrogène est mis au contact de la face du substrat opposée à la face sur laquelle les défauts cristallographiques ont été ou seront formés en étape (ii).

L'hydrogène peut être mis en contact avec la face du substrat opposée à celle sur laquelle les défauts cristallographiques ont été ou seront formés à l'étape (ii), sur une partie de la surface opposée disposée en face à face, selon l'épaisseur du substrat, d'une partie prédéfinie de l'étape (ii).

Selon un mode de réalisation particulièrement préféré, l'hydrogène est mis en contact de la totalité de la face du substrat opposée à la face sur laquelle les défauts cristallographiques ont été ou seront formés en étape (ii).

Selon une variante, l'étape (iv) d'hydrogénation est mise en oeuvre après l'étape (iii) de recuit thermique. De préférence alors, afin de favoriser la diffusion de l'hydrogène au sein des zones riches en dislocations, il est préférable de mettre en oeuvre l'étape (v), tel que décrite ci-après.

Selon une variante préférée, l'étape (iv) d'hydrogénation est effectuée avant l'étape (iii) de recuit thermique, et après l'étape (ii) de formation des régions riches en déformation. L'hydrogène peut notamment être mis au contact du substrat sur les régions prédéfinies selon une méthode classique telle que décrite ci-dessus, et reste concentré dans une région superficielle proche de la face sur laquelle il a été déposé à la fin de l'étape (iv). Dans cette variante, le recuit thermique mis en oeuvre à l'étape (iii) favorise la propagation des dislocations sur toute l'épaisseur du substrat. L'hydrogène déjà mis au contact du substrat diffuse alors le long des canaux induits par les dislocations dans les zones riches en dislocations, sur toute l'épaisseur du substrat.

Dans une autre variante, l'étape (iv) d'hydrogénation peut être mise en oeuvre avant l'étape (ii) de formation des zones riches en déformation. Dans cette variante, l'hydrogène est mis au contact du substrat sans qu'aucun défaut cristallographique n'ait encore été formé conformément à l'étape (ii). L'homme du métier est à même de définir les zones d'hydrogénation du substrat ainsi que les parties prédéfinies d'une face du substrat, de sorte qu'à l'issue de l'étape (iii) de propagation des dislocations, l'hydrogène puisse être présent dans les zones riches en dislocations.

A titre illustratif, il est possible de mettre en contact l'hydrogène avec l'une des faces du substrat, par exemple sous la forme d'une couche hydrogénée sur toute la surface d'une face du substrat, et de former les défauts cristallographiques à l'étape (ii) sur la face opposée à celle sur laquelle la couche hydrogénée est déposée, puis de mettre en oeuvre l'étape (iii) de sorte que les dislocations se propagent sur toute l'épaisseur du substrat et soient ainsi, à l'issue de l'étape (iii), au contact de la couche hydrogénée. L'hydrogène est alors apte à diffuser au sein des zones riches en dislocations par mise en oeuvre de l'étape (v) telle que décrite ci-après, de la face sur laquelle la couche hydrogénée a été déposée vers la face qui lui est opposée.

Dans une autre variante, l'étape (iii) et l'étape (iv) peuvent être effectuées simultanément. Durant le recuit thermique à l'étape (iii), de l'hydrogène peut être déposé sur une face du substrat, par exemple sous la forme d'une couche hydrogénée, de telle sorte à être superposée aux régions riches en déformation formées à l'étape (ii). L'hydrogène peut ainsi diffuser au sein du substrat dès sa mise au contact avec ce dernier.

*Etape (v) : Favorisation de la diffusion de l'hydrogène*

Comme évoqué précédemment, l'étape (v), si existante, peut être réalisée simultanément à l'étape (iii) dans le cas où l'étape (iv) est réalisée préalablement à l'étape (ii) ou préalablement à l'étape (iii). Elle peut aussi être réalisée simultanément à l'étape (vi).

Dans la variante où l'étape (iv) est réalisée entre les étapes (iii) et (vi), l'étape (v) comprend au moins un traitement thermique du substrat.

Lors d'un tel traitement thermique, la concentration en hydrogène dans les zones hydrogénées permet d'amorcer un basculement du type de conductivité de p vers n tout en laissant de type p les zones faiblement-hydrogénées.

Le traitement thermique en étape (v) peut être par exemple opéré par recuit thermique à une température comprise entre 450 °C et 1000 °C, et plus particulièrement comprise entre 650 °C et 800 °C.

La durée du recuit peut être comprise entre 40 minutes et 4 heures, et plus particulièrement entre 30 minutes et 2 heures.

En alternative, la diffusion de l'hydrogène dans les zones riches en dislocations peut être opérée par exposition desdites zones aux ultrasons, en particulier à l'aide de transducteurs piézoélectriques.

Par exemple, on peut utiliser des transducteurs piézoélectriques travaillant entre 20 kHz et 1 MHz, de préférence entre 50 et 500 kHz, des déformations acoustiques induites entre $5 \times 10^{-6}$ et $2 \times 10^{-5}$, et des durées de traitement entre 5 et 120 minutes, préférentiellement entre 10 et 60 minutes.

*Etape (vi) : Traitement thermique*

L'étape (vi) permet l'activation des donneurs thermiques à base d'oxygène dans les zones riches en dislocations 33 pour les convertir en zones dopées n.

Le traitement thermique en étape (vi) peut être par exemple opéré par recuit thermique à une température supérieure ou égale à 350 °C et inférieure ou égale à 550 °C, en particulier allant de 400 °C à 500 °C.

La durée du recuit thermique effectué à l'étape (vi) peut être inférieure ou égale à 100 heures.

Un recuit effectué à une température de 650 °C permet d'annihiler l'ensemble des DT et conduit à retrouver une plaquette de conductivité homogène. Cette caractéristique peut être avantageusement utilisée pour distinguer une plaquette selon l'invention, de plaquettes qui ne seraient pas obtenues par un procédé conforme à l'invention.

## PLAQUETTE DE SILICIUM TYPE P / TYPE N

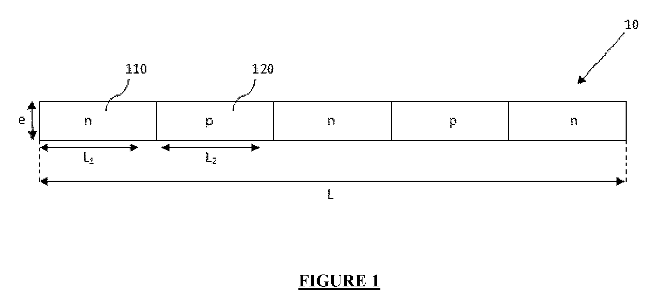

Il est fait référence, dans la description qui suit, à la figure 1 annexée.

Une plaquette 10 de silicium formée selon l'invention peut présenter une épaisseur e allant de 40 $\mu$m à 600 $\mu$m, en particulier de 150 $\mu$m à 250 $\mu$m

Elle peut présenter une longueur totale L, allant de 5 cm à 30 cm, en particulier de 10 cm à 20 cm.

Les plaquettes formées selon l'invention sont de type p / type n.

Comme indiqué précédemment, les zones dopées n 110 de la plaquette formées selon l'invention présentent une concentration en donneurs thermiques à base d'oxygène et une densité de dislocations moyenne supérieures à celles des zones dopées p 120.

Comme il ressort des procédés de réalisation de la plaquette décrits ci-dessous, le contrôle de la concentration locale en DT permet d'accéder à la conductivité électrique alternée n et p de la plaquette.

Deux zones dopées n 110 sont séparées par une zone dopée p 120. Ces zones dopées n 110 et ces zones dopées p 120 sont avantageusement disposées de manière alternée.

Il est en outre à noter qu'il peut exister une « zone de transition » entre les zones dopées p et les zones dopées n, qui est une zone sans porteurs de charge, trop mince pour former une zone électriquement isolante mais qui n'est ni dopée p ni dopée n.

Selon un mode de réalisation particulier, les zones n et p peuvent être agencées de manière à former un motif bidimensionnel.

Par exemple, dans une vue de dessus de la plaquette, la disposition des zones n et p alternées peut former un motif de type quadrillage. Le côté d'un carré (zones n et p) du quadrillage peut être compris entre 1 mm et 10 cm, de préférence entre 5 mm et 5 cm.

Selon un autre mode de réalisation, la disposition des zones n et p alternées peut former un motif de type bande, la largeur d'une bande pouvant être comprise entre 1 mm et 10 cm, de préférence comprise entre 5 mm et 5 cm.

Bien entendu, l'invention n'est nullement limitée à de telles dispositions. Différentes configurations, autres qu'un motif de type quadrillage ou de type bande, peuvent être envisagées dans le cadre de la présente invention (par exemple motifs rectangulaires, polygonaux, etc.).

### *Zones dopées n*

Les zones dopées n 110 de la plaquette sont des zones riches en hydrogène.

Les zones dopées n 110 possèdent une concentration en donneurs thermiques à base d'oxygène comprise entre $6\times10^{13}$ cm$^{-3}$ et $2,5\times10^{16}$ cm$^{-3}$, en particulier comprise entre $10^{15}$ cm$^{-3}$ et $10^{16}$ cm$^{-3}$.

La concentration en donneurs thermiques à base d'oxygène peut être par exemple évaluée par analyse par spectroscopie infrarouge à transformée de Fourier (en langue anglaise « Fourier Transformed InfraRed Spectroscopy » (FTIR)).

Au global, les zones dopées n 110 de la plaquette peuvent présenter, indépendamment les unes des autres, une densité de dislocations moyenne supérieure ou égale à $10^3$ cm$^{-2}$, et de préférence supérieure ou égale à $10^5$ cm$^{-2}$.

De manière générale, la mesure de la densité de dislocations moyenne s'effectue sur une surface de 1 mm$^2$.

Les zones dopées n peuvent présenter, indépendamment les unes des autres, une largeur ($L_1$) supérieure à 1 mm, de préférence allant de 1 mm à 10 cm, en particulier de 5 mm à 5 cm.

Par l'expression « indépendamment les unes des autres », on entend signifier que la largeur peut différer d'une zone dopée à une autre zone dopée de même type.

### *Zones dopées p*

Les zones dopées p 120 de la plaquette formée sont des zones faiblement hydrogénées.

Les zones dopées p 120 possèdent une concentration en donneurs thermiques à base d'oxygène comprise entre $10^{13}$ cm$^{-3}$ et $2\times10^{16}$ cm$^{-3}$, en particulier comprise entre $10^{14}$ cm$^{-3}$ et $5\times10^{15}$ cm$^{-3}$.

Selon un mode de réalisation particulier, les zones dopées p 120 de la plaquette peuvent présenter, indépendamment les unes des autres, une densité de dislocations moyenne inférieure ou égale à $10^3$ cm$^{-2}$, et de préférence inférieure ou égale à $10^2$ cm$^{-2}$.

Les zones dopées p peuvent présenter, indépendamment les unes des autres, une largeur $L_2$ supérieure à 1 mm, de préférence allant de 1 mm à 10 cm, en particulier de 5 mm à 5 cm.

De manière avantageuse, les largeurs $L_1$, $L_2$ peuvent être ajustées selon les connaissances de l'homme du métier. En particulier, les matériaux de type n étant généralement moins sensibles aux impuretés métalliques que les matériaux de type p, les courants photogénérés sont généralement plus élevés dans des zones dopées n que dans des zones dopées p. Ainsi, les largeurs $L_1$, $L_2$ des zones dopées p et dopées n peuvent être adaptées lors de la préparation de la plaquette, en vue notamment d'égaler au mieux ces courants dans la plaquette de silicium finale.

## DISPOSITIFS PHOTOVOLTAIQUES

L'homme du métier est à même de mettre en oeuvre les traitements adéquats classiques, pour l'élaboration d'une cellule photovoltaïque (PV), à partir d'une plaquette formée selon l'invention.

De préférence, à l'issue du procédé de fabrication de la plaquette selon l'invention, on utilise une technologie basse température de type hétérojonction (silicium amorphe sur silicium cristallin), pour la réalisation de la cellule photovoltaïque.

Les cellules PV obtenues selon l'invention peuvent alors être assemblées pour élaborer un module photovoltaïque de taille raisonnable, classiquement de dimension de l'ordre du $m^2$, et présentant une tension accrue par rapport aux modules élaborés à partir de cellules classiques.

Selon encore un autre de ses aspects, l'invention concerne ainsi un module photovoltaïque formé d'un ensemble de cellules photovoltaïques selon l'invention.

L'invention va maintenant être décrite au moyen des exemples suivants, donnés bien entendu à titre illustratif et non limitatif de l'invention.

## EXEMPLE

### Plaquette de silicium monocristallin

Le substrat mis en oeuvre est une plaquette en silicium monocristallin de type p dopée au bore, obtenue par tirage Czochralski. La densité initiale de dislocations est de l'ordre de 100 $cm^{-2}$. La teneur en porteurs trous est de $10^{15}$ $cm^{-3}$, et la concentration en oxygène de $7x10^{17}$ $cm^{-3}$.

Le substrat est de base carrée de dimensions 156 x 156 $mm^2$ et de 200 $\mu m$ d'épaisseur.

L'orientation cristallographique du substrat est (100).

### Formation des zones localisées riches en défauts cristallographiques

La face arrière du substrat est ensuite localement rayée (lignes perpendiculaires), à l'aide d'une micro-pointe en diamant. Les dimensions des zones « rayées », carrées, sont de 4 x 4 $cm^2$. Des outils déjà commercialisés permettent ce type d'application, avec un contrôle précis de la disposition spatiale des rayures (la résolution spatiale peut descendre jusqu'à l'échelle du micromètre) et des conditions mécaniques de gravure (pression exercée sur la pointe).

Les rayures, parallèles, sont espacées d'une distance de 20 $\mu m$.

Sur les carrés rayés, la densité de dislocation sera à l'issue du procédé bien supérieure à $10^3$ $cm^{-2}$.

### Hydrogénation de la surface

Une couche standard de nitrure de silicium hydrogénée est ensuite déposée par PECVD sur la face avant du substrat, selon des procédés connus de l'homme de l'art.

### Propagation des dislocations et diffusion de l'hydrogène

Le substrat subit ensuite un recuit dans un four à tube de 30 minutes à 800 °C sous flux d'azote.

Lors de cette étape de recuit, le substrat est mis en flexion en posant ses deux extrémités sur deux supports constitués de billes de silicium ultra-pur. Au centre de la plaquette, 30 g de billes de silicium ultra-pur sont déposées. Cela entraîne la génération de contraintes mécaniques qui permettent aux dislocations de se propager sur toute l'épaisseur de la plaquette et de définir des régions riches en dislocations.

Lors de ce recuit, l'hydrogène initialement présent dans la couche anti-reflet diffuse dans le volume du matériau, sa migration étant favorisée à partir des zones riches en déformation (zones initialement « rayées »).

Ensuite, la plaquette subit une étape de recuit à 450°C pendant 3 heures. Les régions « sans » dislocations resteront de type p, et les régions riches en dislocations deviennent des zones de type n.

Références :

[1] Pozner et al., Progress in Photovoltaics 20 (2012), 197 ;
[2] US 4,320,247 ;
[3] Wijaranakula, Appl. Phys. Lett. 59 (1991), 1608 ;
[4] Dubois et al., Journal of Applied Physics. 100, 024510 (2006).

## Revendications

1. Procédé de fabrication d'une plaquette (10) d'épaisseur (e), notamment de silicium monolithique type p / type n, comprenant au moins les étapes consistant en :

(i) disposer d'un substrat monolithique en silicium dopé p comprenant une concentration en porteurs de charge de type trous $p_0$ comprise entre $10^{14}$ et $4x10^{16}$ $cm^{-3}$ et une concentration en oxygène interstitiel $[O_i]$ comprise entre $4x10^{17}$ et $2x10^{18}$ $cm^{-3}$ ;

(ii) former des défauts cristallographiques sur des parties prédéfinies d'au moins l'une des faces du substrat, lesdites parties, dites régions riches en déformation, étant espacées les unes des autres d'une distance d comprise entre 5 µm et e/2, la distance d étant mesurée selon une section transversale verticale ;

(iii) soumettre le substrat à un recuit thermique dans des conditions propices à la propagation de dislocations depuis lesdites régions riches en déformation sur toute l'épaisseur du substrat ;

(iv) mettre en contact tout ou partie de l'une des faces du substrat avec de l'hydrogène dans des conditions adaptées à la diffusion de l'hydrogène le long des dislocations propagées à l'étape (iii) ;

(v) si nécessaire, favoriser la diffusion de l'hydrogène ; et

(vi) soumettre le substrat à un traitement thermique dans des conditions propices à l'activation des donneurs thermiques à base d'oxygène dans les zones riches en dislocations pour les convertir en zones n, et obtenir la plaquette attendue.

2. Procédé selon la revendication 1, dans lequel l'étape (iv) est réalisée préalablement à l'étape (ii), préalablement à l'étape (iii), ou entre les étapes (iii) et (vi).

3. Procédé selon la revendication 1, dans lequel l'étape (v) est réalisée simultanément à l'étape (iii), simultanément à l'étape (vi), ou entre les étapes (iii) et (vi).

4. Procédé selon l'une quelconque des revendications 1 à 3, dans lequel lesdites régions riches en déformation sont espacées d'une distance d comprise entre 5 µm et 100 µm, de préférence comprise entre 10 µm et 100 µm.

5. Procédé selon l'une quelconque des revendications 1 à 4, les défauts cristallographiques étant formés en étape (ii) en rayant la surface desdites parties prédéfinies (31;32) à l'aide d'une pointe, en particulier une micro-pointe, de préférence en diamant ou métallique.

6. Procédé selon l'une quelconque des revendications 1 à 5, les défauts cristallographiques étant formés en étape (ii) par exposition de la surface desdites parties prédéfinies (31;32) à un rayonnement laser.

7. Procédé selon l'une quelconque des revendications 1 à 6, dans lequel lesdites parties prédéfinies (31;32) forment un réseau de bandes parallèles ou un quadrillage en surface du substrat.

8. Procédé selon l'une quelconque des revendications 1 à 7, dans lequel le recuit thermique de l'étape (iii) est réalisé sous contraintes mécaniques.

9. Procédé selon l'une quelconque des revendications 1 à 8, dans lequel le recuit thermique en étape (iii) est opérée à une température supérieure ou égale à 450 °C et inférieure ou égale à 1 100 °C, en particulier allant de 500 °C à 900 °C.

10. Procédé selon l'une quelconque des revendications 1 à 9, dans lequel le recuit en étape (iii) est opéré pendant une durée inférieure ou égale à 3 heures, en particulier allant de 5 minutes à 2 heures et plus particulièrement de 10 minutes à 1 heure.

11. Procédé selon l'une quelconque des revendications 1 à 10, dans lequel l'étape (iv) est opérée par implantation ionique d'hydrogène ou dépôt d'une couche comportant de l'hydrogène, notamment de nitrure de silicium hydrogéné.

12. Procédé selon l'une quelconque des revendications 1 à 11, dans lequel l'hydrogène est mis en contact en étape (iv) de la totalité de la surface d'au moins l'une des faces dudit substrat.

13. Procédé selon l'une quelconque des revendications 1 à 12, dans lequel la plaquette (10) est une plaquette de silicium monolithique type p / type n, présentant, dans un plan vertical de coupe, une alternance de zones (110) dopées n et de zones (120) dopées p, **caractérisée en ce que** :

- chacune des zones (110) et (120) s'étend sur toute l'épaisseur (e) de la plaquette,
- deux zones dopées n (110) sont séparées l'une de l'autre dans un plan vertical de coupe par une zone dopée p (120), et
- les zones dopées n (110) présentent une concentration en donneurs thermiques à base d'oxygène et une densité de dislocations moyenne supérieures à celles des zones dopées p (120).

14. Procédé selon l'une quelconque des revendications 1 à 13, dans lequel la plaquette (10) présente des zones dopées n (110) possédant une densité de dislocations moyenne supérieure ou égale à $10^3$ cm$^{-2}$, et de préférence supérieure ou égale à $10^5$ cm$^{-2}$.

15. Procédé selon l'une quelconque des revendications 1 à 14, dans lequel la plaquette (10) présente des zones dopées n (110) possédant une concentration en donneurs thermiques à base d'oxygène comprise entre $6 \times 10^{13}$ et $2,5 \times 10^{16}$ cm$^{-3}$, en particulier comprise entre $10^{15}$ et $10^{16}$ cm$^{-3}$.

16. Procédé selon l'une quelconque des revendications 1 à 15, dans lequel la plaquette (10) présente des zones dopées p (120) possédant une densité de dislocations moyenne inférieure ou égale à $10^3$ cm$^{-2}$, et de préférence inférieure ou égale à $10^2$ cm$^{-2}$.

17. Procédé selon l'une quelconque des revendications 1 à 16, dans lequel la plaquette (10) présente des zones dopées p (120) possédant une concentration en donneurs thermiques à base d'oxygène comprise entre $10^{13}$ et $2\times10^{16}$ cm$^{-3}$, en particulier comprise entre $10^{14}$ et $5\times10^{15}$ cm$^{-3}$.

**FIGURE 1**

**FIGURE 2**

Europäisches
Patentamt

European
Patent Office

Office européen
des brevets

# RAPPORT DE RECHERCHE EUROPEENNE

Numéro de la demande

EP 15 20 1368

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2014/136082 A1 (COMMISSARIAT ENERGIE ATOMIQUE [FR]) 12 septembre 2014 (2014-09-12) * abrégé *; revendications 12-17; figure 3 * * page 13, ligne 1 - page 15, ligne 20 * * page 18, ligne 24 - page 19, ligne 13 * | 1-4,6-17 | INV. H01L31/0352 H01L31/068 H01L31/18 H01L21/761 H01L21/04 H01L31/047 |
| A | SOPORI B L ET AL: "Hydrogen in silicon: diffusion and defect passivation", PROCEEDINGS OF THE PHOTOVOLTAIC SPECIALISTS CONFERENCE. LAS VEGAS, OCT. 7 - 11, 1991; [PROCEEDINGS OF THE PHOTOVOLTAIC SPECIALISTS CONFERENCE], NEW YORK, IEEE, US, vol. CONF. 22, 7 octobre 1991 (1991-10-07) , pages 833-841, XP010039328, DOI: 10.1109/PVSC.1991.169327 ISBN: 978-0-87942-636-1 * page 834, alinéa 3 - alinéa 6 * | 1-17 | |
| A | JOB R ET AL: "Electronic device fabrication by simple hydrogen enhanced thermal donor formation processes in p-type Cz-silicon", 1 avril 2000 (2000-04-01), MATERIALS SCIENCE AND ENGINEERING B, ELSEVIER SEQUOIA, LAUSANNE, CH, PAGE(S) 197 - 202, XP004192047, ISSN: 0921-5107 * abrégé *alinéa 4; figure 4(a) * | 1-17 | DOMAINES TECHNIQUES RECHERCHES (IPC) H01L C30B |
| A,D | US 4 320 247 A (GATOS HARRY C ET AL) 16 mars 1982 (1982-03-16) * abrégé *; revendications 1-18; figures 1-3 * | 1-17 | |

-/--

Le présent rapport a été établi pour toutes les revendications

| Lieu de la recherche | Date d'achèvement de la recherche | Examinateur |
|---|---|---|
| Berlin | 21 avril 2016 | Hamdani, Fayçal |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................................................
& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 15 20 1368

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 2012/140340 A1 (COMMISSARIAT ENERGIE ATOMIQUE [FR]; VEIRMAN JORDI [FR]; DUBOIS SEBASTI) 18 octobre 2012 (2012-10-18) * abrégé *; revendications 1-13; figures 1-5 * * page 1, ligne 4 - ligne 27 * ----- | 1-17 | |
| A | PIVAC B ET AL: "Non-doping light impurities in silicon for solar cells", MATERIALS SCIENCE AND ENGINEERING B, vol. 36, no. 1, 1 janvier 1996 (1996-01-01), pages 55-62, XP028697492, ISSN: 0921-5107, DOI: 10.1016/0921-5107(95)01251-6 * le document en entier * ----- | 1-17 | |
| A | BARAKEL D ET AL: "n-p Junction formation in p-type silicon by hydrogen ion implantation", SOLAR ENERGY MATERIALS AND SOLAR CELLS, ELSEVIER SCIENCE PUBLISHERS, AMSTERDAM, NL, vol. 72, no. 1-4, 1 avril 2002 (2002-04-01), pages 285-290, XP004339776, ISSN: 0927-0248, DOI: 10.1016/S0927-0248(01)00176-3 * le document en entier * ----- | 1-17 | DOMAINES TECHNIQUES RECHERCHES (IPC) |

-/--

Le présent rapport a été établi pour toutes les revendications

| Lieu de la recherche | Date d'achèvement de la recherche | Examinateur |
|---|---|---|
| Berlin | 21 avril 2016 | Hamdani, Fayçal |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 15 20 1368

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | SARIS F W ET AL: "Avoiding dislocations in ion-implanted silicon", MICROELECTRONIC ENGINEERING, ELSEVIER PUBLISHERS BV., AMSTERDAM, NL, vol. 19, no. 1-4, 1 septembre 1992 (1992-09-01), pages 357-362, XP024472925, ISSN: 0167-9317, DOI: 10.1016/0167-9317(92)90453-X [extrait le 1992-09-01] * le document en entier *<br>----- | 1-17 | |
| | | | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| Berlin | 21 avril 2016 | Hamdani, Fayçal |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 & : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 15 20 1368

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-04-2016

| Document brevet cité au rapport de recherche | | | Date de publication | Membre(s) de la famille de brevet(s) | | Date de publication |
|---|---|---|---|---|---|---|
| WO 2014136082 | A1 | | 12-09-2014 | CN 105190863 A | | 23-12-2015 |
| | | | | EP 2965362 A1 | | 13-01-2016 |
| | | | | FR 3003089 A1 | | 12-09-2014 |
| | | | | WO 2014136082 A1 | | 12-09-2014 |
| US 4320247 | A | | 16-03-1982 | AUCUN | | |
| WO 2012140340 | A1 | | 18-10-2012 | CN 103620394 A | | 05-03-2014 |
| | | | | EP 2697632 A1 | | 19-02-2014 |
| | | | | FR 2974180 A1 | | 19-10-2012 |
| | | | | JP 2014518006 A | | 24-07-2014 |
| | | | | KR 20140018928 A | | 13-02-2014 |
| | | | | US 2014033797 A1 | | 06-02-2014 |
| | | | | WO 2012140340 A1 | | 18-10-2012 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4320247 A

**Littérature non-brevet citée dans la description**

- **POZNER et al.** *Progress in Photovoltaics,* 2012, vol. 20, 197
- **WIJARANAKULA.** *Appl. Phys. Lett.,* 1991, vol. 59, 1608
- **DUBOIS et al.** *Journal of Applied Physics,* 2006, vol. 100, 024510